# EUROPEAN PATENT APPLICATION

(11) **EP 2 950 383 A1**
(43) Date of publication of application: **02.12.2015**
(21) Application number: 15166095.8
(22) Date of filing: 30.04.2015
(51) Int. Cl.: H01P 1/19

(54) **DITHERING THE MAGNETIZATION OF A FERRITE LOAD**

(30) Priority: 30.05.2014 US 201414292433
(71) Applicant: Honeywell International Inc., Morristown, NJ 07962-2245 (US)
(72) Inventor: Alexander, Jeffrey, Morristown, NJ New Jersey 07962-2245 (US)
(74) Representative: Houghton, Mark Phillip

(57) **Abstract**

A driver for a ferrite load includes a controller, a clock generator, and a pulse generator. The driver includes a first driver element coupled to the pulse generator and configured to provide a first pulse with a first width that drives a current in a first direction through the load for setting a first magnetic flux. The driver includes a second driver element coupled to the pulse generator and configured to provide a second pulse, having a second width that is independent of the first width, that drives a current in a second, opposite direction through the load for setting a second magnetic flux. The driver includes a feedback input that is configured to receive at least one signal used by the controller to selectively cause the pulse generator to activate one of the first and second driver elements to apply a first or second pulse, respectively, to the load.

## Description

### Background

Ferrite phase shifters are used in waveguides to adjust the phase of RF signals passing through the waveguide. RF energy propagates thorough the waveguide and the ferrite phase shifter. The effective electrical length of the waveguide changes depending on the magnetic interaction of the ferrite with the RF energy propagating through it.

If the ferrite had no magnetic interaction with the RF energy propagating through the waveguide, the contribution to electrical length would only be dependent upon the dielectric constant of the ferrite. This would yield the greatest increase in electrical length. As the magnetic interaction increases the electrical length gets shorter.

A ferrite phase shifter has two saturated conditions referred to the long and short states: The long state is the least interactive and will yield the longest electrical length of the inserted device. In the long state, the magnetic dipoles in the ferrite toroidal loop are counterclockwise in a plane perpendicular to the direction of propagation of the RF energy. The short state is the most interactive and will yield the shortest electrical length of the inserted device. In the short state, the magnetic dipoles in the ferrite toroidal loop are arranged clockwise in the same plane.

The ferrite toroid is a closed loop and the degree of magnetic dipole alignment in a given direction can be modulated to a position anywhere lying between the two saturated states (Long or Short) by varying the voltage and time application of the electronic current pulse applied to a latch wire of the ferrite toroid. If the ferrite toroid is in a saturated condition, the phase value may be modulated by applying a volt/time current pulse in the opposite direction as the volt/time current pulse that caused the saturated condition. Being a closed loop, the current is not held on and the degree of magnetization will remain locked until the next pulse.

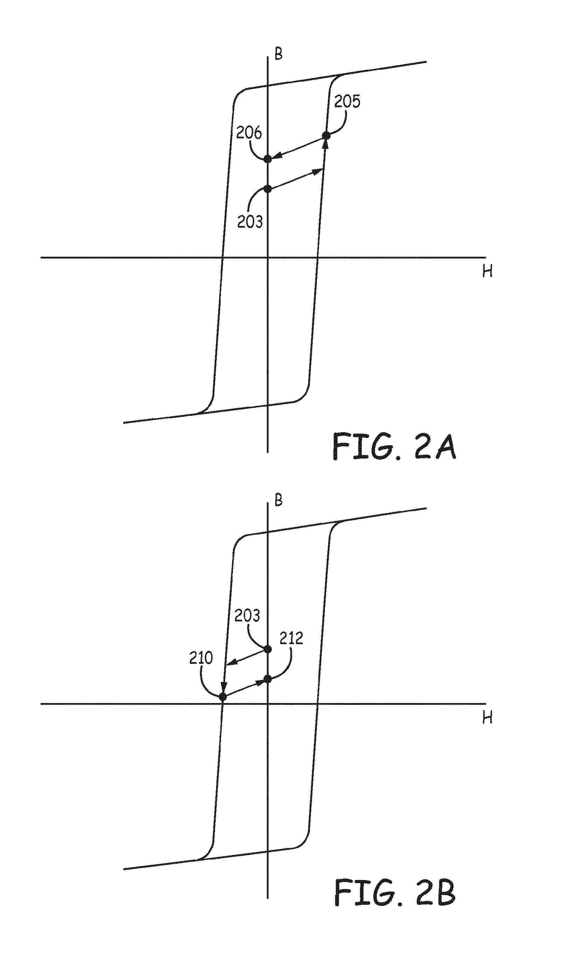

The Magnetic actuation is typically depicted with a hysteresis loop or BH loop (see e.g. Fig. 2A described in more detail below). In the BH loop, H represents the current drive (overcoming Coercive Force) and B is termed the residual or remnant magnitazation value. In this case the magnitization value is proportional to the percentage of dipoles that are either clockwise or counterclockwise. If half of the the dipoles are clockwise and the other half are counterclockwise, the resulting B value would be at approximately 50 percent or near the middle of the BH loop. Where the BH loop crosses the B axis is the residual or remnant magnitization value held after the current pulse is removed. On either opposing end of the B axis are the saturated remnant (all dipoles either cloclwise or counterclockwise), e.g., the Long and Short states.

The latched control is typically greater than 360 degrees of electrical length change commonly referred to as Differential Phase Shift.

In order to maintain an established exacting absolute degree of electrical length interaction a Reset pulse is applied prior to a setting pulse. The Reset pulse is a saturating pulse that aligns all the magnetic dipoles in the counterclockwise orientation placing the magnitization value at one end of the B axis (normally the long state). Once the Reset pulse has occurred a set pulse driving a percentage of the dipoles in the opposite direction can occur. This type of non-saturating timed pulse is termed "flux" drive. The amount of B change caused by the set current pulse is proportional to the voltage and length of time that the set current pulse is applied. Thus, as described in US Patent No. 7,569,951 (the '951 Patent), a stream of events is used to effect a phase adjustment to a ferrite element.

For example, to increase the differential phase by some small amount from a position near the middle of the control range, the ferrite element is subjected to two current pulses; a reset pulse followed by a set pulse. Using this technique, to enact a change in value of roughly 10% a Reset pulse of roughly 50% is followed by a set pulse that is 60% of the BH loop. If this is a 360 degree phase shifter, the ferrite element experienced 396 degrees of phase change in order to move 36 degrees. If a one degree change was desired from the midpoint of the BH loop, 361 degrees of phase change would be required.

As also described in the '951 Patent, the accuracy of establishing a desired phase can be inproved with the addition of another current pulse: the so-called "SuperSet current pulse." With this technique, the Reset current pulse is preceded by the SuperSet current pulse. The SuperSet current pulse is a saturating set pulse that insures that no matter the previous setting state the reset pulse will always be coming from the same state thus erasing any ferrite memory. Without the superset current pulse, the reset current pulse will wander in an amount that will lead the following setting current pulse to wander along with it. Normally the accuracy is good enough for most applications without the need of SuperSet which is used only when very low phase errors can be tolerated. When a SuperSet pulse is used, the total phase shift required to implement a small change is phase is even larger.

In many cases, especially where the transmission media is used for communications, this large disruption in phase change is undesirable and in some cases can cause the link in communication to be lost. Therefore, there is a need in the art for improvements in the manner that phase of a ferrite phase shifter is adjusted.

### Summary

In one embodiment, a driver for a ferrite load is provided. The driver includes a controller, a clock generator that is configured to generate a clock signal, and a pulse generator that is responsive to the clock generator and the controller. The driver also includes a first driver element that is responsive to the pulse generator and is configured to provide a first pulse with a first pulse width that drives a current in a first direction through the ferrite load for setting a first magnetic flux. The driver further includes a second driver element that is responsive to the pulse generator and that is configured to provide a second pulse, having a second pulse width that is independent of the first pulse width, that drives a current in a second, opposite direction through the ferrite load for setting a second magnetic flux. Finally, the driver includes a feedback input, coupled to the controller, the feedback input is configured to receive at least one signal used by the controller to selectively cause the pulse generator to activate one of the first and second driver elements to apply a first or second pulse, respectively, to the ferrite load.

### Brief Description of the Drawings

Understanding that the drawings depict only exemplary embodiments and are not therefore to be considered limiting in scope, the exemplary embodiments will be described with additional specificity and detail through the use of the accompanying drawings, in which:
Figure 1 is a block diagram of a system for dithering the magnetization of a ferrite load according to one embodiment of the present invention.
Figures 2A and 2B are graphs illustrating dithering the magnetization of a ferrite load in the system of Figure 1.
Figure 3 is a block diagram of another embodiment of system for dithering the magnetization of a ferrite load.
Figure 4 is a block diagram of an RF amplifier system with a ferrite load driver that dithers the phase of a ferrite phase shifter according to one embodiment of the present invention.
Figure 5 is a flow chart of a method for controlling the phase of the RF signals in the system of Figure 4.
Figure 6 is a flow chart of a method for dithering the magnetization of a ferrite phase shifter according to one embodiment of the present invention.
Figures 7A and 7B are graphs of one example of dithering the magnetization of a ferrite phase shifter in steps using the method of Figure 6.

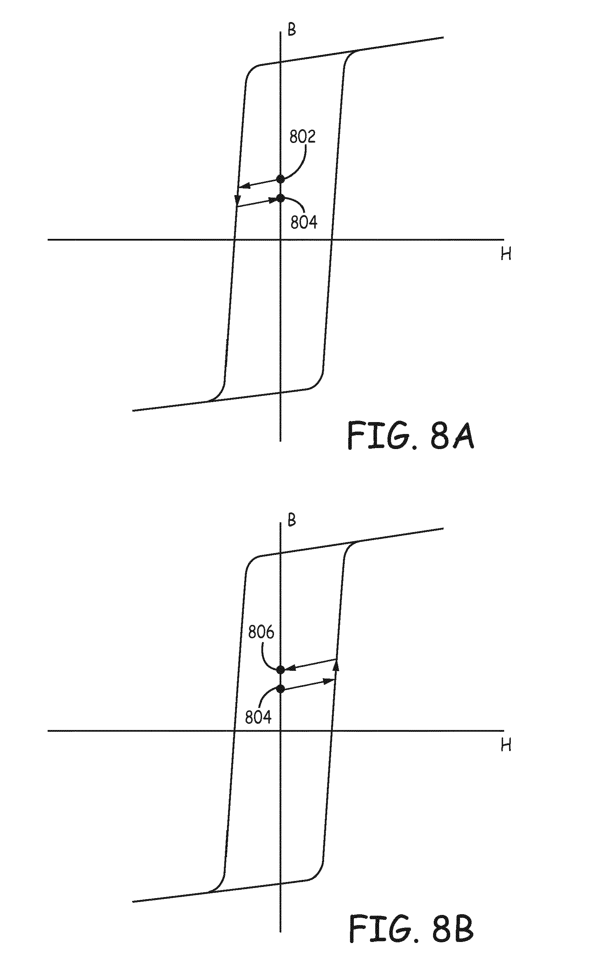

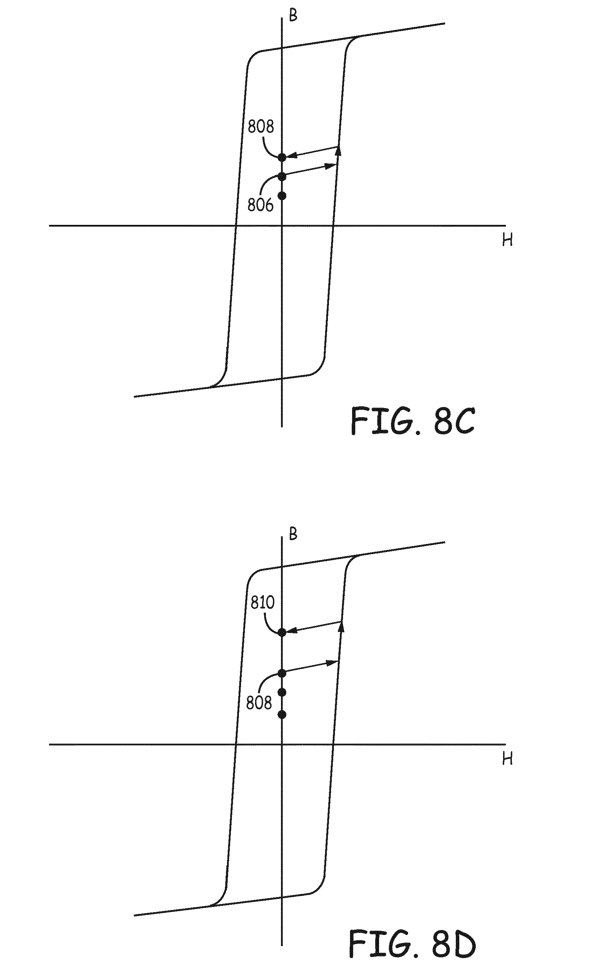

Figures 8A through 8D are graphs of another example of dithering the magnetization of a ferrite phase shifter in steps using the method of Figure 6.

### Detailed Description

In the following detailed description, reference is made to the accompanying drawings that form a part hereof, and in which is shown by way of illustration specific illustrative embodiments. However, it is to be understood that other embodiments may be utilized and that logical, mechanical, and electrical changes may be made. Furthermore, the method presented in the drawing figures and the specification is not to be construed as limiting the order in which the individual steps may be performed. The following detailed description is, therefore, not to be taken in a limiting sense.

The various embodiments in accordance with the invention generally describe a ferrite load driver that can be used to drive a ferrite load in, for example, radio frequency (RF) phase shifting applications. Embodiments of the ferrite load driver digitally generate a pulse having a pulse width equal to a selectable number of clock pulses. The pulse is used for driving a current through the ferrite load for dithering a magnetic flux of the ferrite load. For purposes of this specification, the term "dithering" means to adjust a controllable value, e.g., the magnetic flux, in incremental steps using, for example, an iterative process. In some embodiments, this dithering enables the ferrite load driver to adjust the phase setting of the RF signal passing through the ferrite load.

The amount that the phase (and flux) "dithers" or changes is dependent upon the direction of the dither and the current sate of the ferrite load relative to the two saturated states when the dithering occurs. For example, if the ferrite load is closer to the Long state, a long going dither pulse of a given voltage and time duration will exact a lesser change in flux and phase than a dither of the same magnitude going towards the short state. The assemetry is overcome by applying a greater or lessor length dither or more consecutive dithers.

There are many ways to change the flux of a ferrite load by a selected amount. One method of moving the flux to change the phase by a given amount, e.g., 2 degrees, would be to dither with a current pulse of with magnitude and duration necessary to accomplish this with one pulse. Alternatively, another method would be to use a small dither and issue many current pulses in sucession until the desired flux (and phase) has been reached. It must be noted that the amount of change for a given dither will diminish after some number of consecutive pulses. To compensate for this, once current pulses of a selected magnitude and duration are no longer effective, a dither command with a longer pulse duration can be used until the desired flux (and phase) is acheived.

Dithering the magnetization of the ferrite load provides advantages over conventional ferrite load drivers. Advantageously, dithering the magnetization of the ferrite load enables the phase of an RF signal to be adjusted without interfering with the underlying communication system that transports the RF signal as large phase shifts, e.g., over 360 degrees, are avoided. Such large phase shifts could cause the communication system to lose synchronization even though the unltimate phase change required for the RF signal is only a few degrees.

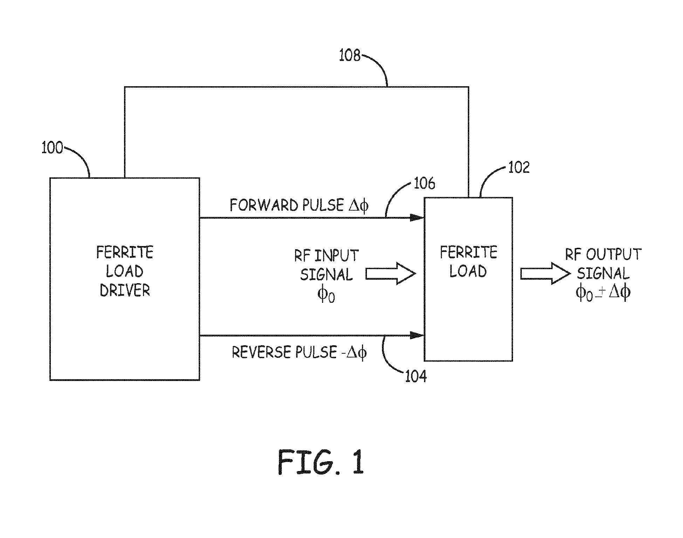

FIG. 1 shows a block diagram of a ferrite load 102 being driven by a ferrite load driver 100 in one exemplary embodiment accordance with the invention. Typically, ferrite load 102 is a ferrite toroid with a coil winding and ferrite yoke backpaths to allow latching operation. The ferrite toroid operates as a latch that can be set to various levels of magnetization by driving a current pulse of a certain magnitude and duration through a coil winding or latch wire. Further, the direction of the current pulse through the coil or latch wire also affects the degree and direction of magnetization established in the ferrite load. For example, a current pulse in a first direction, referred to herein as a forward pulse, on line 106 increases the magnetic flux or magnetization of the ferrite load 102. Similarly, a current pulse in a second direction, referred to herein as a reverse pulse, reverses some of the magnetic dipoles of the ferrite load.

The nature of the forward and reverse current pulses determine the magnitization value (percentage of magnetic dipole alignment that are either clockwise or counterclockwise) generated in ferrite load. In some embodiments, the resulting magnetic flux is used for controlling the phase of an RF signal propagating through ferrite load 102. As shown in FIG. 1, an RF input signal having a phase Φ₀ undergoes a phase shift after propagating through ferrite load 102 and is emitted as an RF output signal with a phase with an incremental phase shift of +/-Δφ.

The ferrite load driver 100 uses feedback to dither the magnetic flux in the ferrite load 102 until a desired outcome is achieved, e.g., a specific magnetization in the ferrite load or other secondary condition such as phase of an RF signal. The ferrite load driver 100 receives a feedback signal 108 at feedback input 110. In one embodiment, the feedback signal 108 relates to a measure of the phase of the RF signal flowing through the ferrite load 102. The ferrite load driver 100 determines whether a forward or reverse pulse is needed to move the magnetic flux in a direction so that the RF signal is driven toward the desired phase. The ferrite load driver 100 repeats this process iteratively, using feedback signal 108, until the desired outcome is reached, e.g., the phase of the RF output signal is at the target level.

Figures 2A and 2B are graphs that illustrate changes in magnetic flux or magnetization of a ferrite load 102 in response to current pulses from a ferrite load driver 100. These graphs show the magnetization change overlayed on the general hysteresis loop or BH loop for the ferrite load 102. In the graphs, H is the current through the latch wire or coil of the ferrite load 102 and B is the magnitization value.

Figure 2A shows an example of flux change in ferrite load 102 corresponding to a forward pulse being driven through the latch wire or coil associated with ferrite load 102. Initially, the magnitization value of ferrite load 102 sits at point 203 along the vertical axis (B). The precise level of magnetization in this initial condition is not important to this example because the ferrite load driver 100 operates by incrementally moving the magnetization in either direction (B value up or down) until a desired magnetization level is achieved. The location of point 203 is therefore chosen for pedagogical purposes only and merely represents the fact that the ferrite load 102 will have some level of non-saturated dipole alignment magnetization when acted on by ferrite load driver 100. To change the residual B value, a current pulse is generated by the ferrite load driver 100 and applied to the ferrite load 102 via forward pulse output 104. This causes the magnetization in ferrite load 102 to transition from point 203 to an intermediate flux state represented by point 205. After the pulse ends, the magnetization in ferrite load 102 transitions to point 206. The amount of change in magnetic flux from point 203 to 206 due to the forward current pulse depends on the duration and magnitude of the forward current pulse from ferrite load driver 100. In some embodiments, the duration of the current pulse is controlled by a clock signal. Further, in some embodiments, the magnitude of the pulse is controlled by adjusting the voltage level of the pulse using, e.g., a potentiometer. The current pulse can have a width of any appropriate number of pulses of the clock signal. The smaller the number of clock pulses used to generate the current pulse, the smaller the potential incremental change in magnetic flux.

Figure 2B shows an example of flux change in ferrite load 102 corresponding to a reverse pulse being driven through the latch wire or coil associated with ferrite load 102. Initially, the magnetic flux of ferrite load 102 sits at point 203 along the vertical axis (B). As discussed above, the precise level of magnetization in this initial condition is not important to this example. To change the magnetic flux, a current pulse is generated by the ferrite load driver 100 and applied to the ferrite load 102 via reverse pulse output 106. This causes the magnetization in ferrite load 102 to transition from point 203 to an intermediate flux state represented by point 210. After the pulse ends, the magnetization in ferrite load 102 transitions to point 212. The amount of change in magnetic flux from point 203 to 212 caused by the reverse current pulse depends on the duration of the reverse current pulse from ferrite load driver 100 as discussed above.

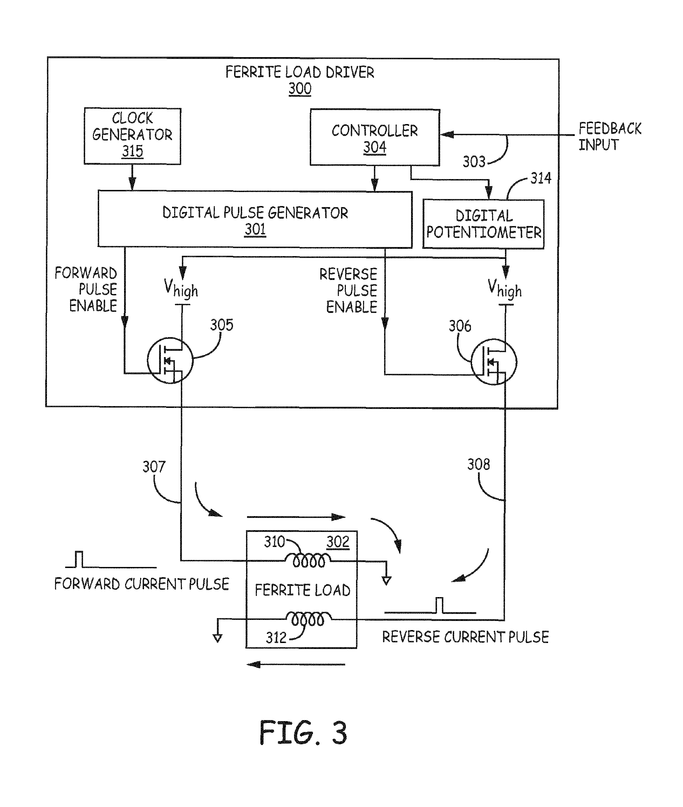

Figure 3 is a block diagram of another embodiment of ferrite load driver 300 for dithering the magnetization of a ferrite load 302. Specifically, ferrite load driver 300 includes a digital pulse generator 301, which digitally generates forward and reverse pulse enable signals using a digital clock provided by clock generator 315. In one embodiment, clock generator 315 provides a clock signal that can be sued bu digital pulse genearator 301 to produce pulses with durations of multiples of 5 nano seconds (Nx5 ns). Ferrite load driver 300 also includes controller 304. Controller 304 receives a feedback signal feedback input 303. The feedback signal typically pertains to setting a desired phase upon a RF signal that passes through the ferrite load 302. Based on the feedback signal, controller 304 instructs digital pulse generator 301 to generate appropriate forward or reverse pulse enable signals.

Ferrite load driver 300 provides output current pulses to ferrite load 302. Specifcally, ferrite load driver includes driver elements 305 and 306. The forward pulse enable signal is coupled to a control terminal of driver element 305. In this exemplary embodiment, the driver element 305 is a field effect transistor (FET) or metal oxide semiconductor field effect transistor (MOSFET) and the control terminal is a gate terminal of the MOSFET. In other embodiments other driver elements may be used. Some non-exhaustive examples of driver elements include solid state devices such as a bi-polar junction transistor (BJT) and a silicon controlled rectifier (SCR). Similarly, the reverse pulse enable signal is coupled to a control terminal of driver element 306. In this exemplary embodiment, driver element 306 is also a MOSFET. In other embodiments, driver element 306 can be other circuit elements such as a BJT, SCR or the like.

The forward pulse enable signal has an amplitude and a pulse width that is selected to drive MOSFET 310 for producing a forward current pulse on electrical link 307. The amplitude of the forward pulse is determined by the supply voltage V_{high} that is provided to MOSFET 310. Consequently, the amplitude of the forward pulse may be tailored to suit the individual requirements of ferrite load 302 by adjusting the value of V_{high}. In some embodiments, V_{high} can be changed on-the-fly. The voltage V_{high} can be changed using such a device as a digital potentiometer 314, under the control of controller 304, to change the voltage regulation to the load or any other appropriate circuitry for adjusting the voltage V_{high}. The forward pulse results in a current flow in a first direction through latch wire or coil 306 of ferrite load 302.

The second pulse enable signal is a reverse pulse enable signal that is coupled, via electrical link 308, to a control terminal of MOSFET 306. The reverse pulse enable signal drives MOSFET 305 to generate a reverse current pulse that may be tailored to suit the individual requirements of ferrite load 302. The reverse current pulse results in a current flow through latch wire or coil 307 of ferrite load 302 in a second direction that is opposite to the first direction.

In one embodiment, latch wires or coils 306 and 307 may be a commonly-shared winding that carries the currents related to the forward and reverse pulses. Suitable switching circuitry may be used to route the forward and reverse current pulses through the commonly-shared winding in opposite directions at different times such as an H bridge. In an alternative embodiment, two independent windings are used.

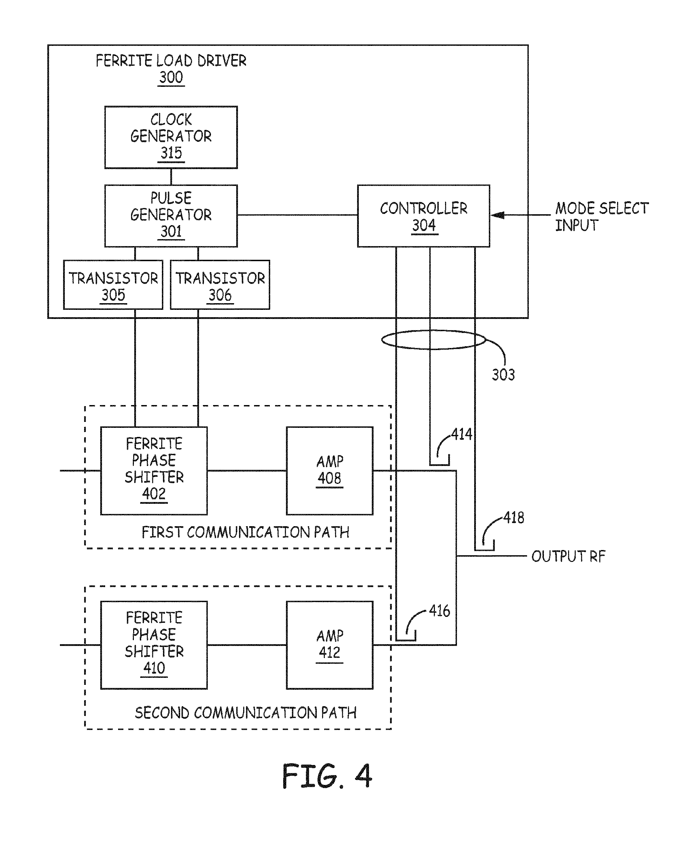

Figure 4 is a block diagram of an RF amplifier system, indicated generally at 400, with a ferrite load driver 300. In one embodiment, ferrite load driver 300 is a multi-modal driver in that it can operate in one of three modes. In a first mode, ferrite load driver actuates a normal reset/set operation as described in the '951 Patent. In a second mode, ferrite load driver 300 operates in a more exacting Superset/Reset/Set as also described in the '951 Patent. Finally, in a third mode of operation (dithering mode), ferrite load driver 300 dithers the phase of a ferrite phase shifter 402 such as described above with respect to Figures 1-3.

In one embodiment, the mode of operation of ferrite load driver 300 is selectable using, for example, the mode select input provided to controller 304. For example, the mode of operation, in one embodiment, is user selectable and is fixedly set at the time of implementation in a system using the mode select input. In other embodiments, the mode of operation of ferrite load driver 300 is settable on-th-fly based on a user input using the mode select input. In further embodiments, such as in a beam forming network, ferrote load driver 300 is operated in the Superset/Reset/set mode of operation to achieve precise initial set-up and then operates in a dithering mode of operation while communications are in session. In other embodiments, other combinations of modes are selected based oncontroller 304 monitoring appropriate conditions related to the accuracy, opreation and other requirements of the system.

In addition to ferrite load driver 300, system 400 includes first and second communication paths 404 and 406. First communication path 404 includes ferrite phase shifter 402 coupled to amplifier 408. Second communication path 406 includes ferrite phase shifter 410 coupled to amplifier 412. The RF output of amplifiers 408 and 412 are combined and provided as an RF output of system 400.

Feedback input 303 of ferrite load driver 300 monitors signals in system 400. Specifically, feedback input 303 is coupled to signal coupler 416 to monitor the output of amplifier 412. Further, feedback input 303 is coupled to signal coupler 414 to monitor the output of amplifier 408. Finally, feedback input 303 is coupled to signal coupler 418 to monitor the combined RF output of system 400.

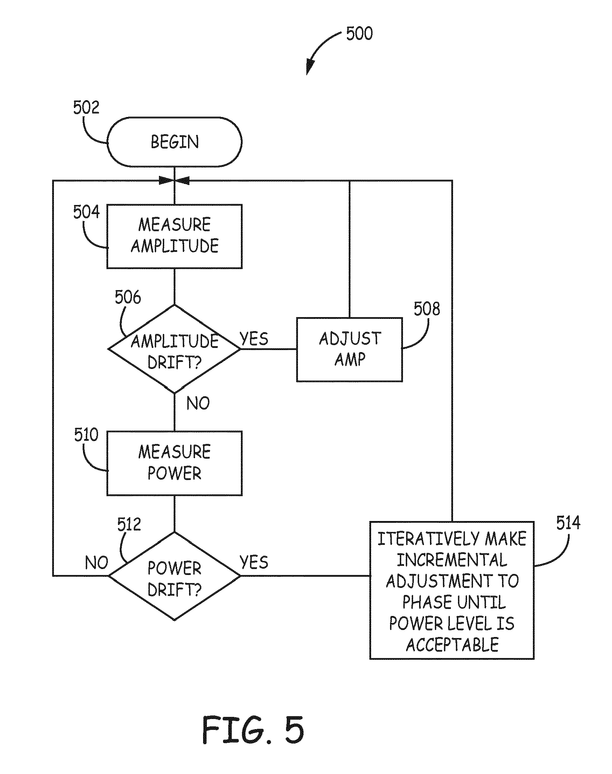

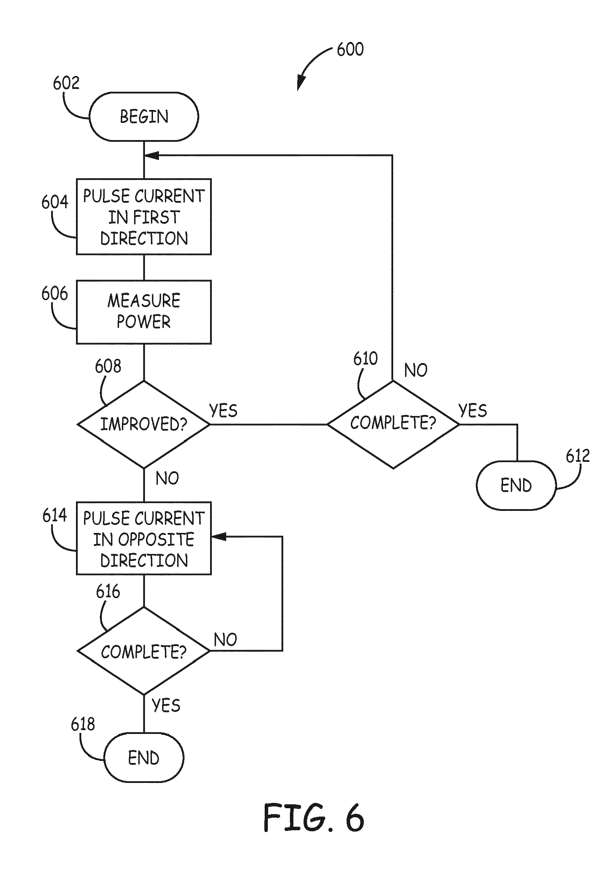

The operation of system 400 in the dithering mode of operation is described in conjuction with the methods of Figures 5 and 6. Figure 5 is a flow chart of a method, indicated generally at 500, for controlling the phase of the RF signals in the system 400 of Figure 4. Method 500 begins at block 502. At block 504, method 500 measures the amplitude of the output of amplifier 408. This measurement is provided through feedback input 303 to controller 304 of ferrite load driver 300. Controller 304 determines, at block 506, whether the amplitude of the signal from amplifier 408 has drifted. If the amplitude has drifted, method 500 proceeds to block 508 and adjusts the amplifier 408 to correct its output. If, however, the amplitude has not drifted, method proceeds to block 510 to consider whether to adjust the phase of the signal input to amplifier 408.

At block 510, method 500 measures power of the output RF at coupler 418. This measured power is provided to feedback input 303 and controller 304. At block 512, controller 304 determines whether power in the output RF has drifted. If the power has not drifted, method returns to block 504. If, however, the power has drifted, controller 304 iteratively and incrementally adjusts the phase of phase shifter 402 at block 514 until the power of the output RF signal is acceptable.

In many cases it will be unknown as to which direction the phase needs to be adjusted. To move the phase to the desired level, the controller 304 begins by issuing a command to generate a short current pulse in one direction, e.g., the forward direction or the reverse direction. If no change is detected, more of the same command could be issued. If still no evidence of change is detected, the length of the dither current pulse would be increased and the same sequence would follow until either the desired condition is reached or it is determined that the result is becoming incrementally worse. If the phase becomes incrementally worse, the direction of dither would need to be reversed and the the described sequence would be reinacted in the opposite direction until the objective is met. It is noted that the process does not wait until a critical imbalance is reached prior to initiation as it has been stated that using this method could incrementalluy worsten the result prior to determining the correct direction. Once the phase of ferrite phase shifter 402 has been adjusted appropriately, method 500 returns to block 504.

Figure 6 is a flow chart of a method, indicated generally at 600, for dithering the magnetization of a ferrite phase shifter 410 according to one embodiment of the present invention. Method 600 comprises one embodiment of a process for implementation in block 514 of figure 5. Thus, method 600 is one technique used to adjust the phase of a ferrite phase shifter such as in a amplifier system of figure 4.

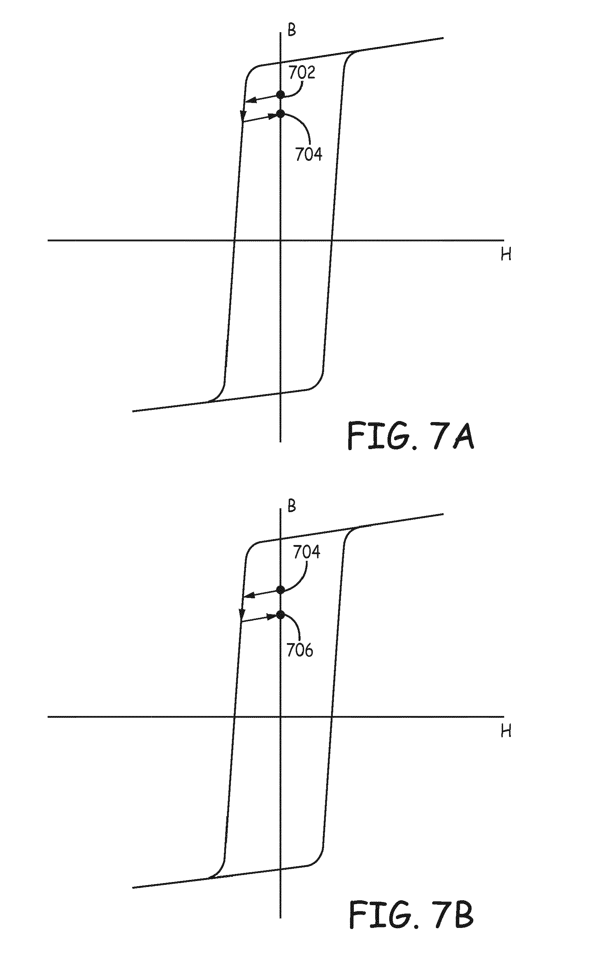

Method 600 begins at block 602. A block 604, controller 304 instructs pulse generator 3012 generate a pulse current in a first direction, e.g. a forward or a reverse current pulse. In the example shown in Figure 7A, pulse generator 301 generates a reverse pulse that moves the magnetic flux of ferrite phase shifter 402 from point 702 to point 704. At block 606, controller 304 measures the power in the output RF signal from coupler 418 and determines if the power measurement has improved block 608. If the power measurement has improved, controller 304 further determines whether the process of restoring the output power level has completed Block 610. If the process has completed, method 600 ends at block 612. If however, power level is still not at the anticipated level, method 600 returns to block 604 to make further adjustment to the phase of ferrite phase shifter 402. Continuing with this example, figure 7B illustrates a second phase adjustment to ferrite phase shifter 402. Again, controller 304 instructs pulse generator 301 to generate another reverse current pulse. This reverse current pulse moves the magnetic flux of ferrite phase shifter 402 from point 704 to point 706. It is noted that controller 304 continued to move the magnetic flux in the same direction because in the prior iteration the measured power showed improvement thus indicating that the phase of the RF signal is moving in the right direction. Controller 304 will continue to provide reverse current pulses to ferrite phase shifter 402 until block 610 indicates that the process is complete, if at some point the continuing pulses no longer cause improovment and the objective has not been met then a larger time value pulse of the same direction will need to be initiated.

If, at block 608, controller 304 determines that the previous adjustment to ferrite phase shifter 402 did not improve the power measurement of the output RF Coupler 418, method 600 proceeds to block 614 to attempt further adjustment of ferrite phase shifter 402 in the opposite direction.

### Example Embodiments

Example 1 includes a driver for a ferrite load, the driver comprising: a controller; a clock generator configured to generate a clock signal; a pulse generator, responsive to the clock generator and the controller; a first driver element, responsive to the pulse generator, and configured to provide a first pulse with a first pulse width that drives a current in a first direction through the ferrite load for setting a first magnetic flux; a second driver element, responsive to the pulse generator, and configured to provide a second pulse, having a second pulse width that is independent of the first pulse width, that drives a current in a second, opposite direction through the ferrite load for setting a second magnetic flux; a feedback input, coupled to the controller, the feedback input is configured to receive at least one signal used by the controller to selectively cause the pulse generator to activate one of the first and second driver elements to apply a first or second pulse, respectively, to the ferrite load.
Example 2 includes the driver of Example 1, wherein the controller is configured to iteratively cause the pulse generator to activate one of the first and second driver elements until a desired magnetization is achieved in the ferrite load.
Example 3 includes the driver of Example 2, wherein the controller is configured to cause the pulse generator to switch from activating the first driver element to activating the second driver element when the feedback signal indicates that activating the first driver element is driving the ferrite load away from the desired magnetization.
Example 4 includes the driver of any of Examples 2-3, wherein the controller is configured to change the duration of the pulse widths provided by the activated one of the first and second driver elements based on an indication from the at least one signal at the feedback input regarding progress toward the desired magnetization.
Example 5 includes the driver of any of Examples 1-4, wherein the feedback input receives a signal indicative of a phase of an RF signal passing through the ferrite load.
Example 6 includes the driver of any of Examples 1-5, wherein the first and second driver elements comprise power transistors that are coupled to a variable power supply coupled to receive a control signal from the controller.
Example 7 includes the driver of any of Examples 1-6, wherein the pulse generator comprises a digital pulse generator that outputs a signal that has a pulse width that is an integer multiple of the clock pulses from the clock generator.
Example 8 includes a method for dithering a ferrite phase shifter, the method comprising: generating a first pulse having a first pulse width based on a digital clock; driving a first current pulse through the ferrite phase shifter in a first direction based on the first pulse; monitoring a signal indicative of a phase of a signal passing through the ferrite phase shifter; if the phase improved based on the first current pulse, driving additional current pulses in the first direction until a desired phase is achieved; and if the phase is not improved, generating a second pulse having a second pulse width that is independent of the first pulse width and is based on the digital clock, and driving one or more second current pulses in a second, opposite direction through the ferrite phase shifter based on the second pulse until the desired phase is achieved.
Example 9 includes the method of Example 8, wherein monitoring the signal indicative of the phase comprises monitoring the signal after each current pulse.
Example 10 includes the method of any of Examples 8-9, wherein monitoring the signal indicative of the phase comprises monitoring the power output of a combining amplifier in a transmission system.
Example 11 includes the method of Example 10, wherein the phase is improved if the power level increases toward a desired level.
Example 12 includes the method of any of Examples 10-11, wherein the phase is not improved if the power level decreases from a prior level.
Example 13 includes the method of any of Examples 8-12, wherein driving additional current pulses when the phase improved comprises driving additional current pulses with the same duration.
Example 14 includes the method of any of Examples 8-13, wherein driving additional current pulses when the phase improved comprises increasing the width of at least one of the additional current pulses.
Example 15 includes the method of any of Examples 8-14, wherein driving one or more second current pulses includes increasing the width of at least one subsequent pulse.
Example 16 includes the method of any of Examples 8-15, wherein driving one or more second current pulse includes driving additional second current pulses with the second, opposite direction.
Example 17. An amplifier system, comprising: a first communication path including a first ferrite phase shifter in series with a first amplifier, the first amplifier having a first output; a second communication path including a second ferrite phase shifter in series with a second amplifier, the second amplifier having a second output; an RF output, coupled to the first and second outputs of the first and second amplifiers; a first coupler, configured to provide a measure of the signal at the first output of the first amplifier; a second coupler, configured to provide a measure of the signal at the second output of the second amplifier; a third coupler, configured to provide a measure of the output at the RF output; a ferrite load driver, coupled to the first ferrite phase shifter and the first, second and third couplers, the ferrite load driver configured to dither the phase of the first ferrite phase shifter based on the output of first, second and third couplers to iteratively adjust the phase on the first ferrite phase shifter.
Example 18 includes the amplifier system of Example 17, wherein the first and second couplers provide a measure of the amplitude of the output of the first and second amplifiers, respectively.
Example 19 includes the amplifier system of any of Examples 17-18, wherein the third coupler provides a measure of the power in the RF output.
Example 20 includes the amplifier system of any of Examples 17-19, wherein the ferrite load driver is configured to iteratively provide incremental current pulses to the first ferrite load until the phase of the first ferrite phase shifter is substantially the same as the phase of the second ferrite phase shifter.
Example 21 includes an amplifier system, comprising: a first communication path including a first ferrite phase shifter in series with a first amplifier, the first amplifier having a first output; a second communication path including a second ferrite phase shifter in series with a second amplifier, the second amplifier having a second output; an RF output, coupled to the first and second outputs of the first and second amplifiers; a first coupler, configured to provide a measure of the signal at the first output of the first amplifier; a second coupler, configured to provide a measure of the signal at the second output of the second amplifier; a third coupler, configured to provide a measure of the output at the RF output; a multi-modal ferrite load driver, coupled to the first ferrite phase shifter and the first, second and third couplers, the ferrite load driver configured to operate in one of a plurality of modes, the plurality of modes including a dither mode in which the phase of the first ferrite phase shifter is adjusted based on the output of first, second and third couplers to iteratively adjust the phase on the first ferrite phase shifter.
Example 22 includes the system of Example 21, wherein the multi-modal ferrite load driver includes a mode select input that selects one of three modes: (1) the dither mode, (2) a Reset/Set mode, and (3) a Superset/Reset/Set mode.
Although specific embodiments have been illustrated and described herein, it will be appreciated by those of ordinary skill in the art that any arrangement, which is calculated to achieve the same purpose, may be substituted for the specific embodiments shown. Therefore, it is manifestly intended that this invention be limited only by the claims and the equivalents thereof.

## Claims

1. A driver (100, 300) for a ferrite load (102), the driver comprising:
a controller (304);
a clock generator (315) configured to generate a clock signal;
a pulse generator (301), responsive to the clock generator and the controller;
a first driver element (305), responsive to the pulse generator, and configured to provide a first pulse with a first pulse width that drives a current in a first direction through the ferrite load for setting a first magnetic flux;
a second driver element (306), responsive to the pulse generator, and configured to provide a second pulse, having a second pulse width that is independent of the first pulse width, that drives a current in a second, opposite direction through the ferrite load for setting a second magnetic flux;
a feedback input, coupled to the controller, the feedback input is configured to receive at least one signal used by the controller to selectively cause the pulse generator to activate one of the first and second driver elements to apply a first or second pulse, respectively, to the ferrite load.

2. The driver of claim 1, wherein the controller is configured to iteratively cause the pulse generator to activate one of the first and second driver elements until a desired magnetization is achieved in the ferrite load.

3. The driver of claim 2, wherein the controller is configured to cause the pulse generator to switch from activating the first driver element to activating the second driver element when the feedback signal indicates that activating the first driver element is driving the ferrite load away from the desired magnetization.

4. The driver of claim 2, wherein the controller is configured to change the duration of the pulse widths provided by the activated one of the first and second driver elements based on an indication from the at least one signal at the feedback input regarding progress toward the desired magnetization.

5. The driver of claim 1, wherein the feedback input receives a signal indicative of a phase of an RF signal passing through the ferrite load.

6. A method (600) for dithering a ferrite phase shifter, the method comprising:
generating a first pulse having a first pulse width based on a digital clock;
driving a first current pulse through the ferrite phase shifter in a first direction based on the first pulse (604);
monitoring a signal indicative of a phase of a signal passing through the ferrite phase shifter (606);
if the phase improved based on the first current pulse, driving additional current pulses in the first direction until a desired phase is achieved (610); and
if the phase is not improved,
generating a second pulse having a second pulse width that is independent of the first pulse width and is based on the digital clock, and
driving one or more second current pulses in a second, opposite direction through the ferrite phase shifter based on the second pulse (614) until the desired phase is achieved (616).

7. The method of claim 6, wherein monitoring the signal indicative of the phase comprises monitoring the signal after each current pulse.

8. The method of claim 6, wherein monitoring the signal indicative of the phase comprises monitoring the power output of a combining amplifier in a transmission system.

9. The method of claim 8, wherein the phase is improved if the power level increases toward a desired level.

10. The method of claim 6, wherein driving one or more second current pulses includes increasing the width of at least one subsequent pulse.
